# EUROPEAN PATENT APPLICATION

(11) **EP 4 249 627 A1**
(43) Date of publication of application: **27.09.2023**
(21) Application number: 23158980.5
(22) Date of filing: 28.02.2023
(51) Int. Cl.: C23C 14/28, C23C 14/22, C23C 4/134

(54) **APPARATUS AND METHOD FOR COATING SUBSTRATE**

(30) Priority: 21.03.2022 GB 202203879
(71) Applicant: Rolls-Royce plc, London N1 9FX (GB)
(72) Inventor: Ushmaev, Dmitrii I, Derby, DE24 8BJ (GB); Liao, Zhirong, Derby, DE24 8BJ (GB); Axinte, Dragos A, Derby, DE24 8BJ (GB); Norton, Andrew D, Derby, DE24 8BJ (GB); Kell, James, Derby, DE24 8BJ (GB)
(74) Representative: Rolls-Royce plc

(57) **Abstract**

An apparatus (100) for coating a surface (104) of a substrate (102) is provided. The apparatus (100) includes an evaporant source (110) disposed within an open environment (108) comprising air at atmospheric pressure. The evaporant source (110) includes a coating material (112). The apparatus (100) further includes an energy beam source (120) disposed within the open environment (108) and configured to emit at least one energy beam (122) that impinges on an emission region (114) of the evaporant source (110) to form a vapour plume (116) at the emission region (114). The vapour plume (116) includes the coating material (112) of the evaporant source (110). The apparatus (100) further includes a fixture (130) configured to position the evaporant source (110) relative to the substrate (102) within the open environment (108), such that a maximum distance (124) between the emission region (114) of the evaporant source (110) and the surface (104) of the substrate (102) is less than or equal to 10 cm.

## Description

### FIELD OF THE DISCLOSURE

The present disclosure relates to an apparatus and a method for coating a substrate.

### BACKGROUND

Protective coatings, such as thermal barrier coatings (TBCs), are usually applied on metallic or non-metallic surfaces of components (e.g., gas turbine engine components) operating at high temperatures. TBCs may limit a thermal exposure of the coated components, thereby extending a service life of such components by reducing oxidation and thermal fatigue, while allowing for higher operating tem peratures.

Conventional techniques for applying TBCs on substrates include air plasma spraying (APS), electron-beam physical vapour deposition (EB-PVD), suspension plasma spraying (SPS), and the like. EB-PVD technique is generally utilized for the components working in harshest conditions, e.g., turbine blades of gas turbine engines, or other dynamic components with combined thermal and mechanical loads, due to their longer lifespan. EB-PVD requires a highly sophisticated deposition setup (e.g., use of vacuum chambers) leading to higher costs for coating the substrates. Further, vacuum-based systems may require time for pumping down the vacuum chamber, leading to increased process times, while also limiting the coating application environment to a specialised laboratory.

Conventional techniques for applying TBCs in atmospheric pressure typically utilize plasma for deposition of coatings. In some techniques, low-frequency nanosecond pulsed laser system is used for ablation of an evaporant (e.g., yttria stabilized zirconia) in an ambient environment. Ablated particles are carried with a flow from a plasma torch and eventually reach a substrate to form a coating layer. Such techniques may require a plasma generator to produce an ionised carrier gas flow to transport the ablated particles. Therefore, such techniques may not be suitable for direct deposition of a coating material onto a substrate.

Most of the coating techniques performed in atmospheric pressure conditions, that do not use a deposition chamber under vacuum, include a plasma generating mechanism to transport the particles of the evaporant. In case of absence of the ionised carrier gas flow, the particles of the evaporant may lose their energy during transport due to a large distance between the evaporant and the substrate. This may cool down the particles which may reach the substrate in solid agglomerates. Therefore, the particles may not properly adhere to the substrate. Moreover, the large distance may increase a number of collisions of the particles with ambient air, and eventually degrade an adhesion quality of the particles of the evaporant.

Other techniques for deposition of the coating material onto the substrate under atmospheric pressure conditions, such as spotless arc directed vapour deposition (SA-DVD), typically utilize an additional anode that ionizes a vapour plume and a jet of gas to form an arc discharge. The arc discharge forms plasma (electrically charged ions), which may then be transported towards the substrate. The substrate may be electrically biased such that the ions may get additional momentum. Such a setup may require the need for the additional anode to conduct the coating process.

The conventionally known techniques of applying TBCs may require a plasma generating mechanism to transport the particles or require a deposition chamber under vacuum. Use of vacuum conditions may require a sophisticated setup and may result in an increased cost of the coating process. Therefore, an improved process of applying TBCs onto the substrate is required which overcomes the above-mentioned problems.

### SUMMARY OF THE DISCLOSURE

According to a first aspect, there is provided an apparatus for coating a surface of a substrate. The apparatus includes an evaporant source disposed within an open environment comprising air at atmospheric pressure. The evaporant source includes a coating material. The apparatus further includes an energy beam source disposed within the open environment and configured to emit at least one energy beam that impinges on an emission region of the evaporant source to form a vapour plume at the emission region. The vapour plume includes the coating material of the evaporant source. The apparatus further includes a fixture configured to position the evaporant source relative to the substrate within the open environment, such that a maximum distance between the emission region of the evaporant source and the surface of the substrate is less than or equal to 10 cm. The maximum distance enables the vapour plume to travel directly from the evaporant source to the surface of the substrate through the open environment, thereby coating the surface of the substrate.

Thus, the maximum distance between the emission region of the evaporant source and the surface of the substrate may enable deposition of the vapour plume directly on the surface of the substrate without the need for vacuum conditions and/or a carrier gas to transport the vapour plume. In other words, as the maximum distance between the emission region of the evaporant source and the surface of the substrate is less than or equal to 10 cm, vacuum conditions or the carrier gas may not be required for coating the surface of the substrate. Therefore, the apparatus of the present disclosure may be simple and convenient as compared to the setups that perform the conventional coating techniques, thereby enabling significant reduction in a cost and a complexity of coating the surface of the substrate.

Additionally, the apparatus may not even require a deposition (or enclosing) chamber and the surface of the substrate may be coated in the open environment. This may further save time and effort required for preparation of the apparatus before coating the surface of the substrate. Moreover, a specialized laboratory environment may not be required with the apparatus of the present disclosure.

With a reduced maximum distance between the emission region of the evaporant source and the surface of the substrate, a number of collisions of particles of the vapour plume with ambient air is also reduced. This may further increase a kinetic energy of the particles of the vapour plume, and eventually improve an adhesion quality when coating the surface of the substrate. Moreover, the increased kinetic energy of the particles of the vapour plume may lead to formation of a durable coating layer on the surface of the substrate.

The apparatus of the present disclosure may not require a plasma generator, which is usually characterised by large dimensions. Thus, the apparatus may be relatively more flexible and miniaturised as compared to the setups that perform the conventional coating techniques. The apparatus of the present disclosure may therefore be more suitable for in-situ coating reapplication on one or more dynamic components of a gas turbine engine. This may further improve a service life of such components, and therefore, improve a productivity of the gas turbine engine.

The apparatus utilizes the vapour plume instead of an ablation plume which is being utilized in conventional coating techniques. Generally, vapour plume is significantly larger than the ablation plume. Further, the vapour plume may be continuously fed by new energy particles from the evaporant source. Moreover, the vapour plume may be constantly energized by the at least one energy beam emitted by the energy beam source. The energy may be delivered to the vapour plume via collision of the particles of the vapour plume with each other. The particles of the vapour plume may not form solid particle agglomerates due to reduced maximum distance between the evaporant source and the substrate. Therefore, in absence of solid particle agglomerates, the coating material (i.e., the vapour plume) may easily adhere to the surface of the substrate. This may be helpful in scaling up the process of coating the substrate to achieve significant growth rates. This may also be helpful in coating difficult to reach portions of the substrate.

A size of the vapour plume may be controlled by adjusting a power of the at least one energy beam. Thus, the at least one energy beam may also provide a higher partial pressure of the vapour plume relative to the atmospheric pressure at the surface of the substrate. The size of the vapour plume may also be controlled by adjusting the maximum distance between the emission region of the evaporant source and the surface of the substrate.

The coating layer produced from coating the surface of the substrate may also generate separated columns on the coating layer similar to columnar-like structure of those produced from electron-beam physical vapour deposition (EB-PVD). Specifically, the separated columns may have a dendritic structure (i.e., not fully dense) with internal pores, similar to the coating layers produced from EB-PVD. The internal porosity may facilitate thermal shock resistance as well as thermal insulation of a material of the substrate. In some applications, the columns in the resulted coating layer may possess a "feather" like structure with an increased porosity. Such a structure may enable extremely low thermal conductivity due to its high degree of porosity. This may help to reduce accumulated thermomechanical stresses in the substrate upon exposure to high temperature conditions.

In some embodiments, the maximum distance is less than or equal to 2 mm and greater than zero. The maximum distance may enable further reduction in the number of collisions of the particles of the vapour plume with the ambient air. As a result, the kinetic energy of the atoms and/or the particles of the vapour plume is increased to a greater extent. This may eventually improve the adhesion quality while coating the surface of the substrate.

In some embodiments, the apparatus further includes a heat source configured to heat the substrate to a predetermined temperature. Heating the substrate to the predetermined temperature may increase a surface energy of the substrate, and thereby enhance adhesion of the coating material to the surface of the substrate. In some cases, the heat source may be a conduction heater, a convection heater, and/or a radiant heater. In some cases, the surface of the substrate may also be heated by one or more energy beams emitted by the energy beam source.

In some embodiments, the predetermined temperature is at least 30% of a melting point of the coating material of the evaporant source. Heating the substrate above 30% of the melting point of the coating material may significantly increase the surface energy of the substrate desirable for optimum adhesion of the coating material to the surface of the substrate.

In some embodiments, the apparatus further includes a gas source configured to generate at least one jet of carrier gas. The at least one jet of carrier gas is configured to at least partially entrain the vapour plume and at least partially assist in transporting the vapour plume to the surface of the substrate. The at least one jet of carrier gas may increase the kinetic energy of the particles of the vapour plume to a greater extent, thereby transporting the vapour plume to the surface of the substrate. This may eventually improve the adhesion quality when coating the surface of the substrate since the at least one jet of carrier gas may locally increase a mean free path of the particles of the vapour plume. Therefore, the number of collisions of the particles of the vapour plume with the ambient air may be reduced. Further, using any inert gas with the gas source may protect a bond coat layer of the substrate from rapid oxidation by creating a non-reactive gas layer at the surface of the substrate when coating the surface of the substrate. In some cases, the gas source may be a combustion torch, which may be easily miniaturised and utilized for gas turbine engine applications.

In some embodiments, the at least one jet of carrier gas is further configured to heat at least the surface of the substrate. Heating the surface of the substrate via the at least one jet of carrier gas may further enhance the adhesion of the coating material to the surface of the substrate.

In some embodiments, the apparatus further includes a bond coater configured to form a bond coat layer of the substrate, such that the bond coat layer defines the surface of the substrate. The bond coat layer may enhance adhesion of the coating material to the surface of the substrate and may reduce a rate of oxidation of the substrate. In some cases, the bond coat layer may form a thin thermally grown (aluminium) oxide (TGO) layer when the bond coat layer is exposed to oxygen at high temperatures during service conditions. The apparatus of the present disclosure may allow the TGO layer to be formed before coating the surface of the substrate, which may prolong a lifespan of the deposited coating layer.

In some embodiments, the apparatus further includes a laser source configured to emit at least one laser beam that is transmitted through the vapour plume, such that the at least one laser beam heats the vapour plume. The laser source is a convergent laser source or a collimated laser source and the at least one laser beam is at least one convergent or collimated laser beam. The at least one laser beam may locally heat the vapour plume and may increase an energy of the vapour plume that may decrease as the vapour plume travels toward the surface of the substrate. This may eventually improve the adhesion quality when coating the surface of the substrate. An intensity of the at least one laser beam may be adjusted for increasing the energy of the vapour plume, as desired.

In some embodiments, the apparatus further includes a heating laser source configured to emit at least one heating laser beam that is transmitted through the vapour plume and impinges on the surface of the substrate. The at least one heating laser beam simultaneously heats the surface of the substrate and the vapour plume. The simultaneous heating of the vapour plume and the surface of the substrate may improve the adhesion quality of the coating onto the surface of the substrate. Additionally, the at least one heating laser beam may help in forming the TGO layer on the bond coat layer to improve durability of the resultant coating layer.

In some embodiments, the energy beam source is a laser source, and the at least one energy beam is at least one laser beam.

According to a second aspect, there is provided a method of coating. The method includes providing an evaporant source within an open environment comprising air at atmospheric pressure. The evaporant source includes a coating material. The method further includes providing a substrate within the open environment. The substrate includes a surface disposed proximal to the evaporant source. The method further includes impinging, via an energy beam source, an emission region of the evaporant source with at least one energy beam to generate a vapour plume at the emission region. The vapour plume includes the coating material of the evaporant source. The method further includes positioning, via a fixture, the evaporant source relative to the substrate within the open environment, such that a maximum distance between the emission region of the evaporant source and the surface of the substrate is less than or equal to 10 cm. The maximum distance enables the vapour plume to travel directly from the evaporant source to the surface of the substrate through the open environment, thereby coating the surface of the substrate.

In some embodiments, the maximum distance is less than or equal to 2 mm and greater than zero.

In some embodiments, the method further includes heating, via a heat source, the substrate to a predetermined temperature.

In some embodiments, the predetermined temperature is at least 30% of a melting point of the coating material of the evaporant source.

In some embodiments, the method further includes generating, via a gas source, at least one jet of carrier gas. The method further includes at least partially entraining the vapour plume in the at least one jet of carrier gas. The method further includes transporting, via the at least one jet of carrier gas, the vapour plume to the surface of the substrate.

In some embodiments, the method further includes heating, via the at least one jet of carrier gas, at least the surface of the substrate.

In some embodiments, the method further includes forming, via a bond coater, a bond coat layer of the substrate, such that the bond coat layer defines the surface of the substrate.

In some embodiments, the method further includes emitting, via a laser source, at least one laser beam. The method further includes transmitting the at least one laser beam through the vapour plume, such that the at least one laser beam heats the vapour plume. The laser source is a convergent laser source or a collimated laser source and the at least one laser beam is at least one convergent or collimated laser beam.

In some embodiments, the method further includes emitting, via a heating laser source, at least one heating laser beam. The method further includes transmitting the at least one heating laser beam through the vapour plume. The method further includes simultaneously heating, via the at least one heating laser beam, the surface of the substrate and the vapour plume.

In some embodiments, the energy beam source is a laser source, and the at least one energy beam is at least one laser beam.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### BRIEF DESCRIPTION OF THE DRAWINGS

Embodiments will now be described by way of example only, with reference to the Figures, in which:
**Figure 1** is a schematic view of an apparatus for coating a surface of a substrate, according to an embodiment of the present disclosure;
**Figure 2** is a schematic view of the apparatus, according to another embodiment of the present disclosure;
**Figure 3** is a schematic view of the apparatus, according to another embodiment of the present disclosure;
**Figure 4** is a schematic view of the apparatus, according to another embodiment of the present disclosure;
**Figure 5** is a schematic view of the apparatus, according to another embodiment of the present disclosure;
**Figure 6** is a schematic view of the apparatus, according to another embodiment of the present disclosure;
**Figure 7** is a schematic sectional view of the substrate and a coating layer produced by coating the substrate, according to an embodiment of the present disclosure;
**Figure 8** is a flowchart illustrating a method of coating, according to an embodiment of the present disclosure;
**Figure 9** is a schematic view of an apparatus for coating a substrate, according to an embodiment of the present disclosure; and
**Figure 10** is a schematic view of a laser apparatus, according to an embodiment of the present disclosure.

### DETAILED DESCRIPTION

Aspects and embodiments of the present disclosure will now be discussed with reference to the accompanying figures. Further aspects and embodiments will be apparent to those skilled in the art.

Chemical elements are discussed in the present disclosure using their common chemical abbreviations, such as commonly found on a periodic table of elements. For example, hydrogen is represented by its common chemical abbreviation H; helium is represented by its common chemical abbreviation He; and so forth.

As used herein, the term "coating" generally refers to application or deposition of a material (e.g., a protective material) onto a surface of a substrate to form a layer (e.g., a protective coating) on the surface of the substrate. The term refers not only to the deposition of the material on the surface of the substrate, but the deposited material may also extend from the surface inwardly into an interior of the substrate.

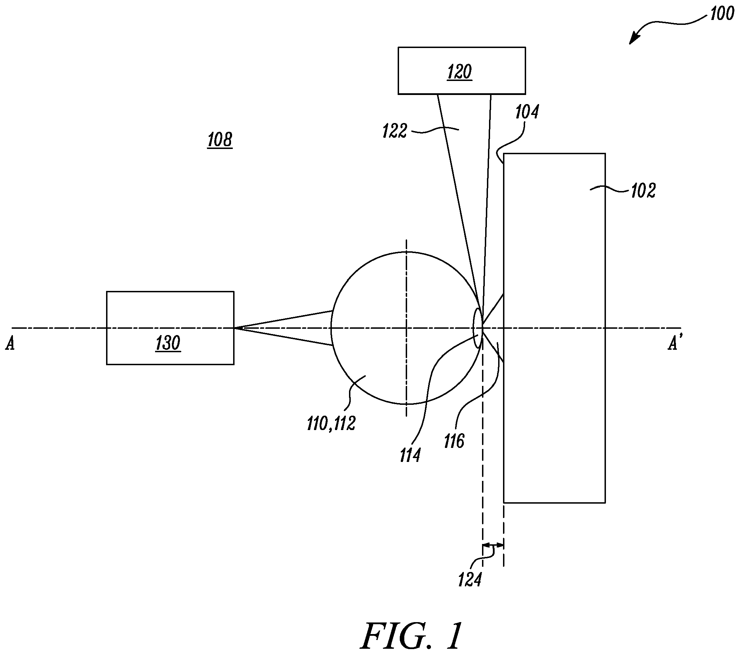

Figure 1 illustrates a schematic view of an example of an apparatus 100 for coating a surface 104 of a substrate 102. In some embodiments, the apparatus 100 may be utilized for coating on the surface 104 of the substrate 102 through direct vapour deposition techniques. In some embodiments, the substrate 102 may be a part or a portion of a gas turbine engine. In some embodiments, the coating may be a thermal barrier coating (TBC) that may protect the substrate 102 from hot gases and may increase an operational life of the substrate 102 by preventing failure due to oxidation and thermomechanical fatigue. The apparatus may produce a coating layer on the surface 104 of the substrate 102. In some embodiments, the coating layer may be a multi-layered coating layer. It should be understood that the substrate 102 is shown schematically in Figure 1, and the actual shape and geometry of the substrate 102 may vary based on application requirements.

The apparatus 100 includes an evaporant source 110 disposed within an open environment 108 comprising air at atmospheric pressure. As used herein, the term "open environment" generally refers to a non-constrained and a non-pressure controlled environment. In other words, the surface 104 of the substrate 102 may be coated without using vacuum conditions or an enclosure. In some embodiments the evaporant source 110 includes yttria-stabilized zirconia (YSZ), however, generally any suitable ceramic material may be utilized. The evaporant source 110 includes a coating material 112.

In some embodiments, the evaporant source 110 may include any material that may be used to generate a desirable coating layer, such as the TBC. In some embodiments, the coating material 112 may include one or more materials from the group consisting of yttrium monosilicate, yttrium disilicate, rare-earth silicates, alkaline-earth aluminosilicates, such as barium-strontium-aluminosilicate, niobium oxide, tantalum oxide, zirconium oxide, hafnium oxide, yttrium oxide, titanium oxide, mullite, rare-earth oxides, and mixtures and compounds thereof. In some other embodiments, the coating material 112 may include a variety of metal sources including, but not limited to, aluminium, chromium, tantalum, niobium, silicon, molybdenum, hafnium, titanium, zirconium, platinum, palladium, gold, or mixtures and alloys thereof.

The apparatus 100 further includes an energy beam source 120 disposed within the open environment 108 and configured to emit at least one energy beam 122 that impinges on an emission region 114 of the evaporant source 110 to form a vapour plume 116 at the emission region 114. In some embodiments, the at least one energy beam 122 from the energy beam source 120 may locally heat the evaporant source 110 at the emission region 114 to vaporise the evaporant source 110, thereby generating the vapour plume 116. The vapour plume 116 includes the coating material 112 of the evaporant source 110. In some embodiments, the vapour plume 116 may include particles of the coating material. The "at least one energy beam 122" is interchangeably referred to hereinafter as "energy beam 122".

In some embodiments, the energy beam source 120 is a laser source, and the at least one energy beam 122 is at least one laser beam. In some embodiments, the energy beam 122 may include a continuous-wave laser beam or a high repetition pulsed laser with nanosecond or larger pulse duration. A high repetition rate for the energy beam 122 is necessary for generation of a constant pool of the molten coating material 112 and maintaining the vapour plume 116. The continuous-wave laser beam may have an irradiance of about 1.5 watts per millimetre square (W/mm²) to about 500 W/mm². In some embodiments, the continuous-wave laser beam may have an irradiance of about 5 W/mm² to about 150 W/mm². In some embodiments, the continuous-wave laser beam may have an irradiance of about 10 W/mm² to about 25 W/mm². In some embodiments, the energy beam source 120 may emit multiple energy beams 122, however, only one energy beam 122 is shown for illustrative purposes.

In some embodiments, an energy of the vapour plume 116 may be constantly pumped with incoming energy of the energy beam 122 and may be delivered to the vapour plume 116 via atomic collisions between the particles. A size and a length of the vapour plume 116 may be controlled by controlling a power of the energy beam source 120, thereby achieving a high partial pressure of the vapour plume 116 relative to the at atmospheric pressure at the surface 104 of the substrate 102. In some embodiments, the power is a laser power. In some embodiments, the laser power of the energy beam source 120 may be scalable, considering that a laser spot size can be varied. In some embodiments, the continuous-wave laser beam may have the laser power of about 1 W to about 5000 W. In some embodiments, the continuous-wave laser beam may have the laser power of about 1 W to about 1000 W. In some embodiments, the continuous-wave laser beam may have the laser power of about 1 W to about 100 W. In some embodiments, the size of vapour plume 116 may also be controlled with change in a distance between the emission region 114 and the surface 104 of the substrate 102.

When an interface between the emission region 114 in liquid state (heated by the energy beam 122) and the surrounding air is not disturbed, it remains stable, effectively suppressing subsurface boiling, and therefore, explosive ejection of the emission region 114 in liquid state. An energy density of the energy beam 122 for achieving these conditions were found to be between 200 Joules per millimetre square (J/mm²) and 1000 J/mm². By moving the energy beam 122 over the emission region 114 with aforementioned conditions, it may be possible to achieve a steady-state pure evaporation (generating the vapour plume 116) with suppressed boiling. The energy density of the energy beam 122 may be finely adjusted to supress fragmentation and boiling, therefore achieving a pure vapour phase. A linear speed of a laser spot of the energy beam 122 on the emission region 114 may have a wide range, and may achieve pure evaporation between 2 millimetres per second (mm/s) and 150 mm/s in the aforementioned energy density range.

In some embodiments, pure vaporisation may also be achieved by using ultrashort lasers. In such cases, the ultrashort lasers may have a pulse width of about 1 millisecond (ms) to about 1 femtosecond (fs). In some embodiments, the ultrashort lasers may have the pulse width of about 1 picosecond (ps) to about 1 femtosecond (fs). In some embodiments, the ultrashort lasers may have the pulse width of about 100 fs to about 1 fs. In some embodiments, the ultrashort lasers may have a pulse energy of about 1 millijoules (mJ) to about 1 mJ. In some embodiments, the ultrashort lasers may have the pulse energy of about 1 mJ to about 100 mJ. In some embodiments, the ultrashort lasers may have the pulse energy of about 1 mJ to about 10 mJ.

The apparatus 100 further includes a fixture 130 configured to position the evaporant source 110 relative to the substrate 102 within the open environment 108, such that a maximum distance 124 between the emission region 114 of the evaporant source 110 and the surface 104 of the substrate 102 is less than or equal to 10 centimetres (cm). The maximum distance 124 enables the vapour plume 116 to travel directly from the evaporant source 110 to the surface 104 of the substrate 102 through the open environment 108, thereby coating the surface 104 of the substrate 102. The maximum distance 124 may further enable increase in the partial pressure of the vapour plume 116 at the surface 104 of the substrate 102.

In some embodiments, the fixture 130 positions the evaporant source 110 along a deposition axis A-A' of the substrate 102. The vapour plume 116 may travel directly from the evaporant source 110 to the surface 104 of the substrate 102 along the deposition axis A-A'. In some embodiments, coating the surface 104 of the substrate 102 may generate a layer of the coating material 112 on the surface 104 of the substrate 102. In some embodiments, the layer may have a thickness of about 0.1 to 1 millimetres (mm). Coating of the surface 104 of the substrate 102 is not constrained to a pressure-controlled environment, such as vacuum or a sealed container.

In some embodiments, the fixture 130 may releasably hold the evaporant source 110 relative to the substrate 102 within the open environment 108. In some embodiments, the fixture 130 may manipulate the evaporant source 110 during formation of the vapour plume 116. For example, the fixture 130 may rotate the evaporant source 110 or may change a position or orientation of the evaporant source 110 to maintain the vapour plume 116 and the maximum distance 124 between the emission region 114 and the surface 104 of the substrate 102.

In some embodiments, the maximum distance 124 is less than or equal to 8 cm, less than or equal to 5 cm, less than or equal to 2 cm, or less than or equal to 1. In some embodiments, the maximum distance 124 is less than or equal to 2 mm and greater than zero. In some embodiments the maximum distance 124 is less than or equal to 100 micrometres (µm). In some embodiments the maximum distance 124 is less than or equal to 50 µm. The vapour plume 116 may get condensed in air and the energy of the vapour plume 116 may continuously decrease with increasing distance from the surface 104 of the substrate 102. By decreasing the maximum distance 124 between the emission region 114 of the evaporant source 110 and the surface 104 of the substrate 102, it may be possible to decrease a number of atomic collisions, thereby increasing a kinetic energy of the particles within the vapour plume 116, leading to a higher adhesion of the coating material 112 to the surface 104 of the substrate 102. Moreover, the increased kinetic energy of the particles of the vapour plume 116 may lead to formation of a durable coating layer on the surface 104 of the substrate 102.

The maximum distance 124 between the emission region 114 of the evaporant source 110 and the surface 104 of the substrate 102 may enable deposition of the vapour plume 116 directly on the surface 104 of the substrate 102 without the need for vacuum conditions and/or a carrier gas to transport the vapour plume 116. Therefore, the apparatus 100 of the present disclosure may be simple and convenient as compared to the setups that perform the conventional coating techniques, thereby enabling significant reduction in a cost and a complexity of coating the surface 104 of the substrate 102.

In some embodiments, while the vapour plume 116 is thermalized, it is possible to select preferential atoms for deposition by applying a mask (not shown) between the evaporant source 110 and the surface 104 of the substrate 102. Assuming a homogeneous velocity magnitude distribution in the vapour plume 116, the atoms with higher vector component aligned with the deposition axis A-A' may be selected via the mask, while the atoms with misaligned velocity may adhere to the mask. The degree of misalignment may be controlled by adjusting a thickness of the mask.

The apparatus 100 utilizes the vapour plume 116 generated from the evaporant source 110 instead of an ablation plume utilized in conventional coating techniques. Generally, a vapour plume is significantly larger than an ablation plume. Ablation plume may have a tendency to produce solid particle agglomerates that may not adhere to the surface 104 of the substrate 102. Use of the vapour plume 116 is more beneficial than ablation plume because of the energy that the vapour plume 116 already contains. Further, the vapour plume 116 may be continuously fed by new energy particles from the evaporant source 110. The particles of the vapour plume 116 may not form solid particle agglomerates due to the maximum distance 124 between the evaporant source 110 and the substrate 102. Therefore, in the absence of solid particle agglomerates, the coating material 112 (i.e., the vapour plume 116) may easily adhere to the surface 104 of the substrate 102. This may be helpful in coating difficult to reach portions of the substrate 102.

The apparatus 100 of the present disclosure may be simple, convenient, more flexible, miniaturisable, and may be customized based on application requirements. The apparatus 100 may not necessarily require use of a carrier gas to transport the vapour plume 116 towards the surface 104 of the substrate 102. Further, the apparatus 100 may not require a deposition chamber under vacuum, an electron gun, or a gaseous precursor. The apparatus 100 may be suitable for in-situ coating reapplications. This may further save time and effort required for preparation of the apparatus 100 before coating the surface 104 of the substrate 102. Additionally, the apparatus 100 may vaporise and deposit the coating material 112 at high rates and may simultaneously deposit different coating materials 112 in precise elemental ratios for alloying purposes. Moreover, a specialized laboratory environment may not be required with the apparatus 100 of the present disclosure.

In the illustrated embodiment of Figure 1, the evaporant source 110 is shown schematically for descriptive and illustrative purposes. In some examples, the evaporant source 110 may be cylindrical. However, the evaporant source 110 may be of any shape and size based on application requirements. Further, the surface 104 of the substrate 102 may or may not be planar.

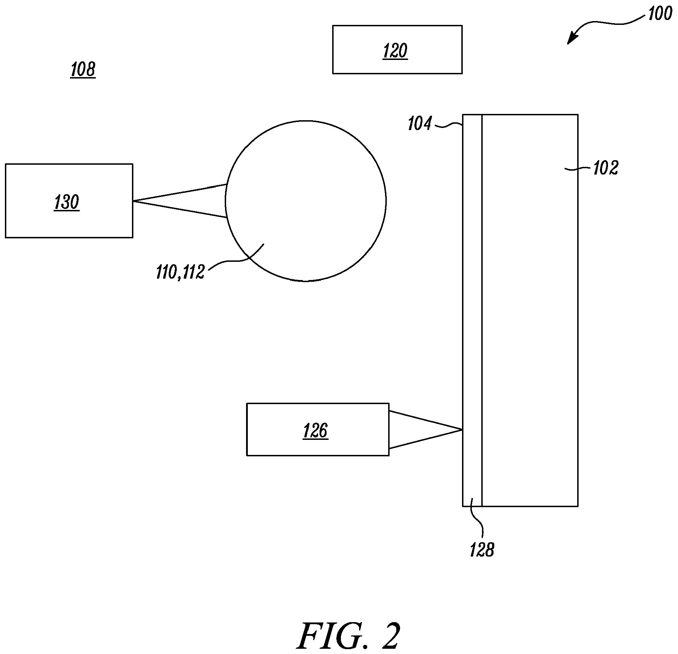

Figure 2 illustrates a schematic view of another example of the apparatus 100. In some embodiments, the apparatus 100 includes a bond coater 126 configured to form a bond coat layer 128 of the substrate 102, such that the bond coat layer 128 defines the surface 104 of the substrate 102. In some embodiments, the bond coat layer 128 may enhance adhesion of the coating material 112 to the surface 104 of the substrate 102 and may reduce a rate of oxidation of the substrate 102.

In some embodiments, the bond coat layer 128 may include an aluminium containing alloy, such as MCrAlY where M = Nickel (Ni) and/or Cobalt (Co), or an aluminium-based intermetallic, such as nickel aluminide, containing varying amounts of platinum (Pt) and/or rare earth elements, such as hafnium (Hf). In some embodiments, the bond coat layer 128 may be formed by the bond coater 126 using any suitable forming technique known in the art depending on a material system of the bond coat layer 128. For example, the bond coat layer 128 that includes MCrAlY may be formed using low pressure plasma spray (LPPS), electron beam physical vapour deposition (EB-PVD), high-velocity oxy fuel (HVOF), detonation gun (D-Gun), combustion flame spray (CFS), air plasma spray (APS), and occasionally by sputtering. The bond coat layer 128 that includes aluminide may typically be formed using diffusion-based processes. Such processes may include pack cementation, vapour phase aluminiding (VPA), or chemical vapour deposition (CVD). However, any other process know in the art may be utilized for forming the bond coat layer 128 on the substrate 102.

In some embodiments, the bond coat layer 128 may form a thin thermally grown (aluminium) oxide (TGO) layer when the bond coat layer 128 is exposed to oxygen at high temperatures during service conditions (e.g., YSZ as the TBC may be oxygen transparent when exposed to high temperatures). The oxygen ions may penetrate through the TBC and react with the bond coat layer 128, generating an oxide layer (i.e., the TGO layer), preferably consisting of α-Al₂O₃. This TGO layer is formed on the surface 104 of the aluminium-rich bond coat layer 128 by a chemical (oxidation) reaction. The Al₂O₃ may act as an oxygen barrier and may reduce an oxidation rate of the bond coat layer 128. At the same time, the TGO layer may increase its volume during oxidation that may lead to generation of large compressive stresses when constrained by the bond coat layer 128 on one side and the TBC on the other.

Creating a TGO thin layer prior to coating the surface 104 of the substrate 102 may help in reducing the stresses arising from constrained growth. Additionally, the TGO layer may impede oxidation and hot corrosion of the substrate 102. The apparatus 100 of the present disclosure may allow a homogenous TGO layer to be grown in a controlled environment before coating the substrate 102, which may prolong a lifespan of the deposited coating layer. Thus, it may be possible to grow the TGO layer before coating the surface 104 of the substrate 102.

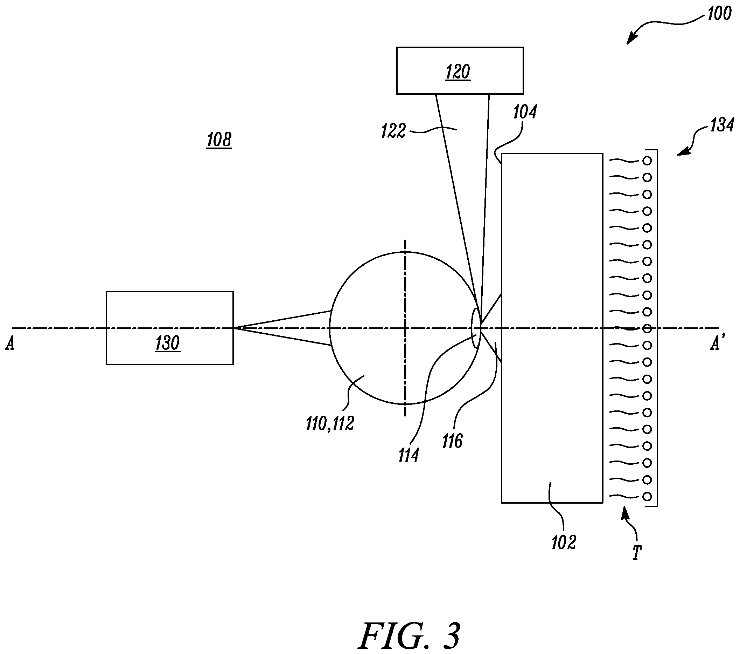

Figure 3 illustrates a schematic view of another example of the apparatus 100. The apparatus 100 further includes a heat source 134 configured to heat the substrate 102 to a predetermined temperature T. In some embodiments, heating the substrate 102 to the predetermined temperature T may increase a surface energy of the substrate 102, thereby enhancing adhesion of the coating material 112 to the surface 104 of the substrate 102. In some embodiments, the predetermined temperature T is at least 30% of a melting point of the coating material 112 of the evaporant source 110. Heating the substrate 102 above 30% of the melting point of the coating material 112 may significantly increase the surface energy of the substrate 102 desirable for optimum adhesion of the coating material 112 to the surface 104 of the substrate 102. In some examples, for YSZ as the coating material 112, the predetermined temperature T is at least 780 degrees Celsius (°C).

In the illustrated embodiment of Figure 3, the substrate 102 is heated externally from a bottom side. However, the substrate 102 may be heated from any side. In some embodiments, the heat source 134 may include a conduction heater, an induction heater, a radiation heater, or generally any convection heat source. In some embodiments, the surface 104 of the substrate 102 may also be heated using the energy beam source 120, or a different laser source, that may allow even higher surface temperatures to be achieved.

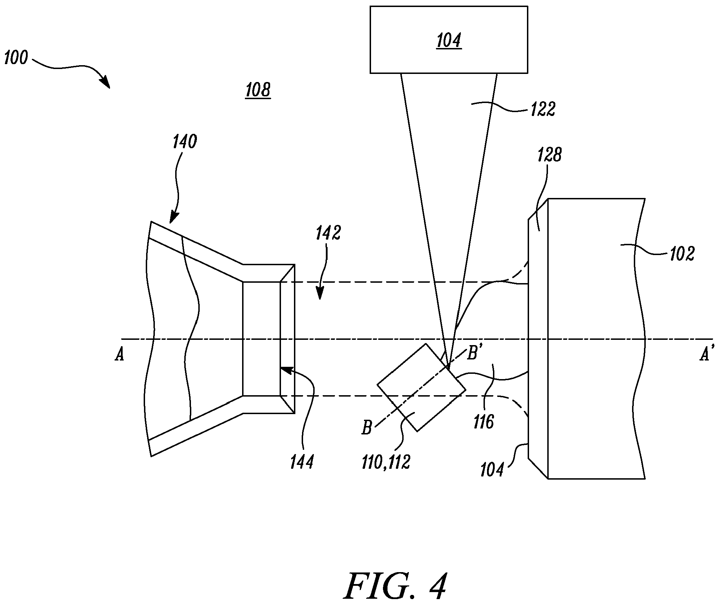

Figure 4 illustrates a schematic view of another example of the apparatus 100. In the illustrated embodiment of Figure 4, the evaporant source 110 is arranged differently as compared to the apparatus 100 of Figures 1 and 3. Specifically, an axis B-B' of the evaporant source 110 is inclined with respect to the deposition axis A-A' of the substrate 102.

In some embodiments, the apparatus 100 further includes a gas source 140 configured to generate at least one jet of carrier gas 142. In some embodiments, the gas source 140 arranged along the deposition axis A-A' of the substrate 102. In some embodiments, the gas source 140 includes an orifice 144, such as a pipe, conduit, tube, channel, hose, stem, duct, port, groove, passage, or tunnel, that ejects the at least one jet of carrier gas 142. The "at least one jet of carrier gas 142" is interchangeably referred to hereinafter as the "jet of carrier gas 142".

In some embodiments, the gas source 140 may include a combustion torch or an electrical heater, i.e., a plasma arc torch or a tungsten coil heater, with a noble gas, such as Helium (He) or Argon (Ar). In some embodiments, the carrier gas may be predominantly ionized. Examples of the carrier gas may include one or more of any combination of the following: inert (e.g., Helium), reactive (e.g., Nitrogen, Hydrogen, Oxygen), or ion-forming (Argon, Xenon, or Krypton); as well as any other type of suitable carrier gases.

In some embodiments, the at least one jet of carrier gas 142 is configured to at least partially entrain the vapour plume 116 and at least partially assist in transporting the vapour plume 116 to the surface 104 of the substrate 102. Specifically, the jet of carrier gas 142 at least partially assists in transporting the vapour plume 116 to the surface 104 of the substrate 102 along the deposition axis A-A'. In some embodiments, a momentum of the jet of carrier gas 142 assists in the transport of the vapour plume 116 toward the surface 104 of the substrate 102. Thus, the jet of carrier gas 142 may increase a kinetic energy of the vapour plume 116, thereby assisting in transportation of the vapour plume 116 towards the surface 104 of the substrate 102. Additionally, the jet of carrier gas 142 may increase a mean free path of the particles constituting the vapour plume 116, thereby reducing collision between the particles and ambient air and subsequent cooling of the vapour plume 116. The kinetic energy of the vapour plume 116 may dictate adhesion of the coating material 112 to the surface 104 of the substrate 102 and eventually a durability of the coating layer produced.

In some embodiments, the at least one jet of carrier gas 142 is further configured to heat at least the surface 104 of the substrate 102. This may increase a surface energy of the surface 104, thereby enhancing adhesion of the coating material 112 to the surface 104 of the substrate 102. Additionally, the jet of carrier gas 142 may protect the bond coat layer 128 from rapid oxidation (where the carrier gas is an inert gas), thereby preventing generation of non-reactive layer at the surface 104 of the substrate 102. In some embodiments, an output flow from the gas source 140 may be homogenized by using a gas lens (not shown). The gas lens may be a metallic grid positioned before a heating element of the gas source 140, that may allow a laminar flow of the jet of carrier gas 142.

In some embodiments, a direction and/or an intensity of the jet of carrier gas 142 may be controlled for shaping and/or directing of the vapour plume 116 towards the surface 104 of the substrate 102. The shaping and/or directing of the vapour plume 116 may be accomplished by controlling a pressure and/or a gas flow rate of the jet of carrier gas 142. In the illustrated embodiment of Figure 4, the gas source 140 is positioned coaxial with the deposition axis A-A' of the substrate 102. However, the gas source 140 may also be inclined with respect to the deposition axis A-A'. In some embodiments, the at least one jet of carrier gas 142 may include multiple jets of carrier gas 142. Additionally, a relative pressure and/or a gas flow rate of the multiple jets of carrier gas 142 may be individually controlled for directional sweeping of the vapour plume 116.

In some embodiments, the jet of carrier gas 142 may include reactant gases. In some embodiments, the reactant gases may form compounds with the atoms or molecules of the coating material 112 constituting the vapour plume 116 during transport of the vapour plume 116 in the jet of carrier gas 142. In some embodiments, the reactant gases may form compounds through a chemical reaction upon deposition on the surface 104 of the substrate 102. Alternatively, the reactant gases may form compounds through both the aforementioned modes.

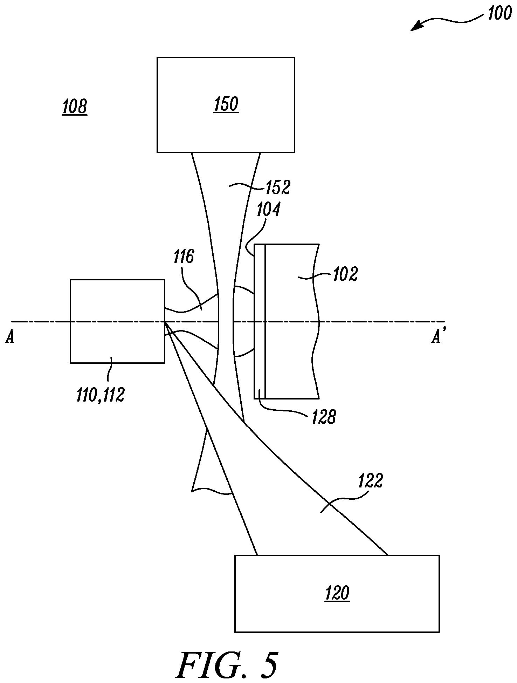

Figure 5 illustrates a schematic view of another example of the apparatus 100. In some embodiments, the apparatus 100 further includes a laser source 150 configured to emit at least one laser beam 152 that is transmitted through the vapour plume 116. In some embodiments, the laser source 150 is a convergent laser source or a collimated laser source. Further, the at least one laser beam 152 is at least one convergent laser beam or collimated laser beam. The "at least one laser beam 152" is interchangeably referred to hereinafter as the "laser beam 152".

Kinetic energy of the vapour plume 116 may decrease as the vapour plume 116 travels directly from the evaporant source 110 to the surface 104 of the substrate 102 along the deposition axis A-A'. In some embodiments, the at least one laser beam 152 heats the vapour plume 116. In other words, the laser beam 152 may locally heat up the vapour plume 116, thereby increasing the kinetic energy of the vapour plume 116 as the vapour plume 116 travels from the evaporant source 110 to the surface 104 of the substrate 102.

This may eventually improve the adhesion quality when coating the surface 104 of the substrate 102. In some embodiments, the laser source 150 may be similar to the energy beam source 120 (shown in Figure 1).

In some other embodiments, the apparatus may include only one energy beam source, i.e., the energy beam source 120 (shown in Figure 1) and the laser beam 152 may be emitted by the energy beam source 120 (shown in Figure 1). For example, the laser beam 152 may be obtained by splitting the energy beam 122 or a separate energy beam from the energy beam source 120. In some embodiments, a laser wavelength of the laser beam 152 may be reduced to submicrometre level (e.g., 535 nanometres or below), and a power density of the laser beam 152 at a beam waist may be higher than 1 kilowatt per millimetre square (kW/mm²) to add energy to the vapour plume 116 efficiently.

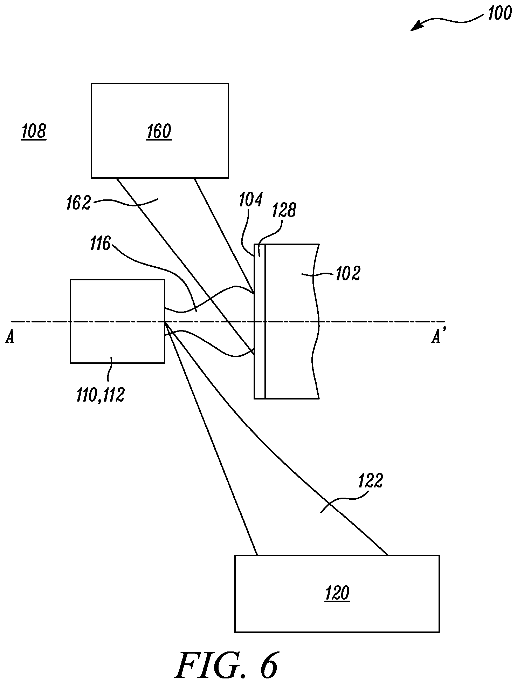

Figure 6 illustrates a schematic view of another example of the apparatus 100. In some embodiments, the apparatus 100 further includes a heating laser source 160 configured to emit at least one heating laser beam 162 that is transmitted through the vapour plume 116 and impinges on the surface 104 of the substrate 102. The "at least one heating laser beam 162" is interchangeably referred to herein as the "heating laser beam 162".

The at least one heating laser beam 162 simultaneously heats the surface 104 of the substrate 102 and the vapour plume 116. This may enhance adhesion of the vapour plume 116 with the surface 104 of the substrate 102. This approach may be more beneficial for heating the substrate 102 since heating is localised and the substrate 102 may reach higher temperatures than the ones achieved via any other heat sources (e.g., the heat source 134 shown in Figure 3).

In some embodiments, the heating laser beam 162 may be used to heat the surface 104 of the substrate 102 when the bond coat layer 128 is present and generate the TGO layer on the surface 104. In some embodiments, generation of the TGO layer may be controlled by a path geometry of the heating laser beam 162. In some embodiments, the heating laser beam 162 may heat the surface 104, the TGO layer, and a coating structure that is being deposited, thereby achieving temperatures higher than a melting point of the substrate 102. The TGO layer and/or the deposited coating structure may be able to withstand a higher temperature than the melting point of the substrate 102, and may be locally overheated to increase bonding of the deposited coating structure with the substrate 102.

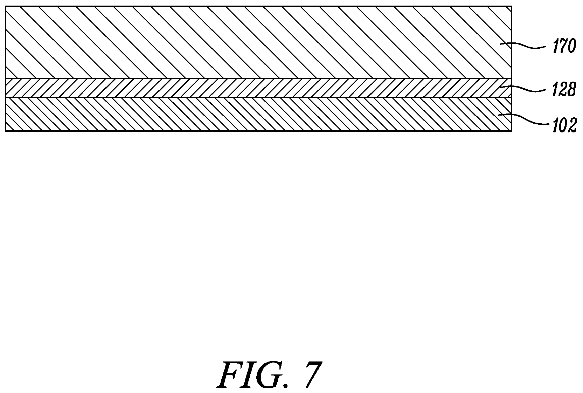

Figure 7 illustrates a schematic sectional view of the substrate 102 and a coating layer 170 produced by coating the substrate 102 using the apparatus 100 shown with reference to Figures 1 to 6. The bond coat layer 128 is disposed between the coating layer 170 and the substrate 102. The substrate 102, the bond coat layer 128, and the coating layer 170 may together form a coated article.

The coating layer 170 may include separated columns on the coating layer 170 similar to columnar-like structure of those produced from electron-beam physical vapour deposition (EB-PVD). Specifically, the separated columns may have a dendritic structure (i.e., not fully dense) with internal pores, similar to coating layers produced from EB-PVD. The internal porosity may facilitate thermal shock resistance as well as thermal insulation of a material of the substrate 102. To generate a porous columnar structure, it is important to utilize vapour plume 116 only.

In some embodiments, the columns in the coating layer 170 may possess a "feather" like structure with an increased porosity. Such a structure may enable extremely low thermal conductivity due to its high degree of porosity. This may help to reduce accumulated thermomechanical stresses in the substrate 102 upon exposure to high temperature conditions. It should be noted that post-deposition annealing may be required to provide a required density and stiffness of the coating layer 170. This may include a localised heat treatment, possible using either a thermal spray or a laser beam head.

In some embodiments, the columns in the coating layer 170 may possess a solgel like structure, consisting of spherical elements with a size of about 10 to 1000 nanometres. An example of this structure may be achieved with a distance between the substrate 102 and the evaporant source 110 (shown in Figures 1-6) of about 100 µm or more, and the laser power of about 100 watts (W). Propagating vapour plume 116 (shown in Figures 1 and 3-6) may condense into nanometrescale spherical elements, and may be deposited onto the substrate 102. Compared to traditional "bottom-up" approach, the apparatus 100 (shown in Figures 1-6) may allow a one-step "dry" coating fabrication, at the same time producing no chemical waste. Such a structure may enable extremely low thermal conductivity due to its high degree of porosity. This may help to reduce accumulated thermomechanical stresses in the substrate 102 upon exposure to high temperature conditions. Further, it should be noted that post-deposition annealing may be required to provide a required density and stiffness of the coating layer 170. This may include a localised heat treatment, possible using either a thermal spray or a laser beam head.

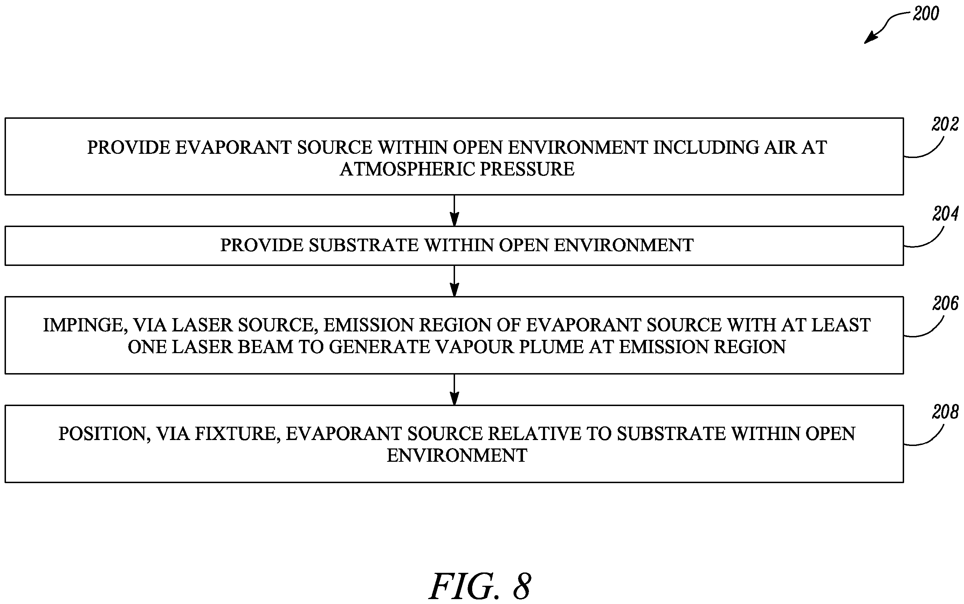

Figure 8 is a flow chart illustrating a method 200 of coating. The method 200 will be described hereinafter with reference to the apparatus 100 of Figures 1-6.

At step 202, the method 200 includes providing the evaporant source 110 within the open environment 108 including air at atmospheric pressure. The evaporant source 110 includes the coating material 112. At step 204, the method 200 further includes providing the substrate 102 within the open environment 108. The substrate 102 includes the surface 104 disposed proximal to the evaporant source 110. In some embodiments, the method 200 further includes forming, via the bond coater 126, the bond coat layer 128 of the substrate 102, such that the bond coat layer 128 defines the surface 104 of the substrate 102.

At step 206, the method 200 further includes impinging, via the energy beam source 120, the emission region 114 of the evaporant source 110 with the at least one energy beam 122 to generate the vapour plume 116 at the emission region 114. The vapour plume 116 includes the coating material 112 of the evaporant source 110. In some embodiments, the method 200 further incudes heating, via the heat source 134, the substrate 102 to the predetermined temperature T. In some embodiments, the predetermined temperature T is at least 30% of the melting point of the coating material 112 of the evaporant source 110.

At step 208, the method 200 further includes positioning, via the fixture 130, the evaporant source 110 relative to the substrate 102 within the open environment 108, such that the maximum distance 124 between the emission region 114 of the evaporant source 110 and the surface 104 of the substrate 102 is less than or equal to 10 cm. The maximum distance 124 enables the vapour plume 116 to travel directly from the evaporant source 110 to the surface 104 of the substrate 102 through the open environment 108 thereby coating the surface 104 of the substrate 102. In some embodiments, the maximum distance 124 is less than or equal to 2 mm and greater than zero.

In some embodiments, the method 200 further includes generating, via the gas source 140, the at least one jet of carrier gas 142. In some embodiments, the method 200 further includes at least partially entraining the vapour plume 116 in the at least one jet of carrier gas 142. In some embodiments, the method 200 further includes transporting, via the at least one jet of carrier gas 142, the vapour plume 116 to the surface 104 of the substrate 102. In some embodiments, the method 200 further includes heating, via the at least one jet of carrier gas 142, at least the surface 104 of the substrate 102.

In some embodiments, the method 200 further includes emitting, via the laser source 150, the at least one laser beam 152. In some embodiments, the method 200 further includes transmitting the at least one laser beam 152 through the vapour plume 116, such that the at least one laser beam 152 heats the vapour plume 116.

In some embodiments, the method 200 further includes emitting, via the heating laser source 160, the at least one heating laser beam 162. In some embodiments, the method 200 further includes transmitting the at least one heating laser beam 162 through the vapour plume 116. In some embodiments, the method 200 further includes simultaneously heating, via the at least one heating laser beam 162, the surface 104 of the substrate 102 and the vapour plume 116.

In some embodiments, the proposed method 200 may be used to repair existing coating layers. A damaged area may be first cleaned and a topology of the original coating layer may be modified to provide an ideal interface with sufficient roughness for application of a repair path. In some embodiments, a maskant around the repair patch may need to be applied. It is imperative to ensure that the repair path and the existing coating layers are appropriately matched in order for the repair patch to survive service conditions. The repair patch may have a different microstructure, and thus, different process parameters may be utilized for edges of the repair patch as compared to a centre of the repair patch. A post-deposition heat treatment, and post-repair surface smoothing (i.e., to remove asperities and improve airflow properties), may also be considered.

### EXAMPLES

The following examples are offered for illustrative purposes only and are not intended to limit the scope of the disclosure in any way. Indeed, various modifications of the disclosure in addition to those shown and described herein will become apparent to those skilled in the art from the foregoing description and the following examples and fall within the scope of the appended claims.

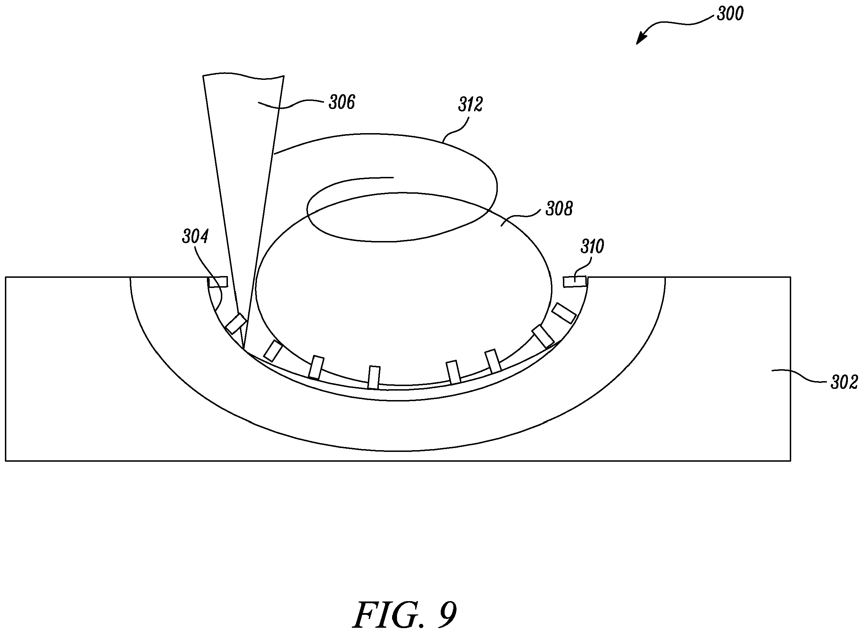

Deposition of a vapour plume on a surface of a substrate in atmospheric pressure was checked in an experiment using an apparatus 300 described with reference to Figure 9. As shown in Figure 9, a substrate 302 was irradiated with a laser beam 306 on a surface 304 of the substrate 302. The substrate 302 included Zirconia. The laser beam 306 followed a spiral path 312 that generated a vapour plume 308 consisting of zirconia. The laser beam 306 had a power of 100 watts (W) and a diameter of 0.4 millimetres (mm) that generated the vapour plume 308 of 2 mm. The spiral path 312 was defined as an Archimedes spiral.

The vapour plume 308 got deposited on the same surface 304 of the substrate 302. Deposition from the vapour plume 308 generated a structure 310 with columns about 3 µm wide and about 20 µm in height obtained in conditions of static spiral.

The laser beam 306 simultaneously heated the surface 304 of the substrate 302 and the structure 310. The columns were separated from each other and had a dendritic structure, i.e., not fully dense and had internal porosity. The internal porosity not only helped to accommodate thermal stresses, but also increased thermal insulation because of an entrapped non-conducting material (e.g., air).

In the extreme cases of highest energy densities, the columns had a "feather" like structure with an ultimate porosity. The porosity may vary from 0% to 50%. Resultant porosity may depend on nucleation modes, a direction, and a density of the vapour plume 308. Potentially, it may be possible to produce a fully dense coating layer with high vapour temperature and limited volume of newly obtained atoms by moving a nucleation mode from Volmer-Weber island formation (separated columns) to Frank-van de Merve island formation.

The above described method may be utilized as a coating restructuring technique, i.e., restructuring of previously deposited coatings (e.g., by thermal spray techniques) consisting of splats. These splats may be molten by generating a vapour plume, which may redeposit on itself with a different microstructure.

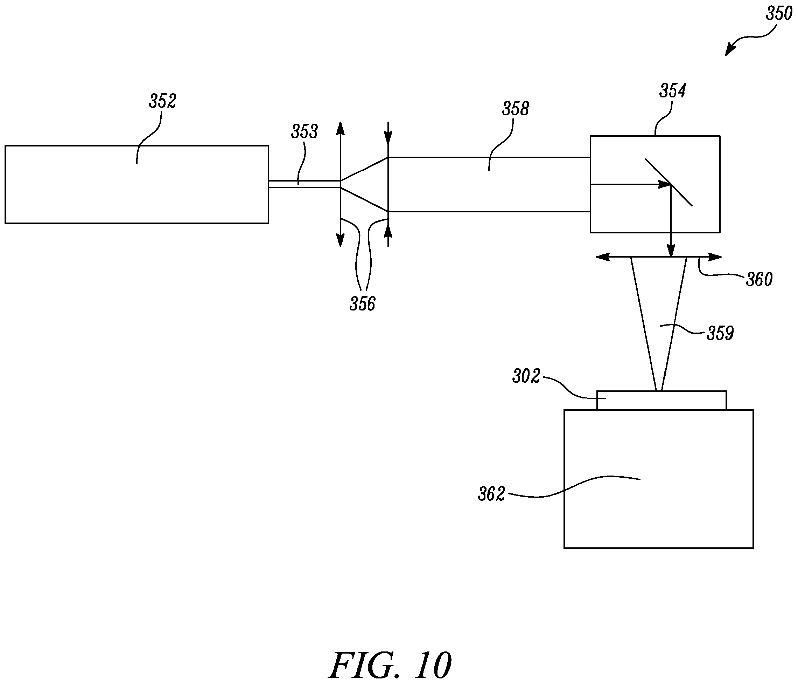

Figure 10 illustrates a schematic view of a laser apparatus 350. In some embodiments, the laser apparatus 350 was used for irradiating the surface 304 (shown in Figure 9) of the substrate 302 for generation of the vapour plume 308 (shown in Figure 9).

In the illustrated embodiment of Figure 10, the laser apparatus 350 included a pulsed laser source 352 that generated a laser beam 353. The laser beam 353 was passed through one or more beam expanders 356 that generated an expanded laser beam 358. The expanded laser beam 358 was then directed towards a galvanometer optical scanner 354 that reflected the expanded laser beam 358 towards a focusing lens 360. The expanded laser beam 358 was further passed through the focusing lens 360 and formed a focussed laser beam 359 that was utilized for heating the surface 304 (shown in Figure 9) of the substrate 302 mounted on a stage 362. In some embodiments, the stage 362 was able to move along its respective x, y and z axes.

Although the present disclosure has been described with reference to a metallic, superalloy, article for a gas turbine engine, the present disclosure is equally applicable to a metallic, superalloy, article for aero gas turbine engines, marine gas turbine engines, automotive gas turbine engines, or industrial gas turbine engines. The present disclosure is equally applicable to metallic, superalloy, articles for other turbomachines, e.g., steam turbines, or other apparatus requiring metallic, superalloy, articles with thermal barrier coatings.

It will be understood that the invention is not limited to the embodiments above-described and various modifications and improvements can be made without departing from the concepts described herein. Except where mutually exclusive, any of the features may be employed separately or in combination with any other features and the disclosure extends to and includes all combinations and subcombinations of one or more features described herein.

## Claims

1. An apparatus (100) for coating a surface (104) of a substrate (102), the apparatus (100) comprising:
an evaporant source (110) disposed within an open environment (108) comprising air at atmospheric pressure, the evaporant source (110) comprising a coating material (112);
an energy beam source (120) disposed within the open environment (108) and configured to emit at least one energy beam (122) that impinges on an emission region (114) of the evaporant source (110) to form a vapour plume (116) at the emission region (114), the vapour plume (116) comprising the coating material (112) of the evaporant source (110); and
a fixture (130) configured to position the evaporant source (110) relative to a substrate (102) within the open environment (108), such that a maximum distance (124) between the emission region (114) of the evaporant source (110) and a surface (104) of the substrate (102) is less than or equal to 10 cm, wherein the maximum distance (124) enables the vapour plume (116) to travel directly from the evaporant source (110) to the surface (104) of the substrate (102) through the open environment (108) thereby coating the surface (104) of the substrate (102).

2. The apparatus (100) of claim 1, wherein the maximum distance (124) is less than or equal to 2 mm and greater than zero.

3. The apparatus (100) of claim 1 or claim 2, further comprising a heat source (134) configured to heat the substrate (102) to a predetermined temperature (T).

4. The apparatus (100) of any one of claims 1 to 3, further comprising a gas source (140) configured to generate at least one jet of carrier gas (142), wherein the at least one jet of carrier gas (142) is configured to at least partially entrain the vapour plume (116) and at least partially assist in transporting the vapour plume (116) to the surface (104) of the substrate (102).

5. The apparatus (100) of any one of claims 1 to 4, further comprising a bond coater (126) configured to form a bond coat layer (128) of the substrate (102), such that the bond coat layer (128) defines the surface (104) of the substrate (102).

6. The apparatus (100) of any one of claims 1 to 5, further comprising a laser source (150) configured to emit at least one laser beam (152) that is transmitted through the vapour plume (116), such that the at least one laser beam (152) heats the vapour plume (116), wherein the laser source (150) is a convergent laser source or a collimated laser source and the at least one laser beam (152) is at least one convergent or collimated laser beam.

7. The apparatus (100) of any one of claims 1 to 6, further comprising a heating laser source (160) configured to emit at least one heating laser beam (162) that is transmitted through the vapour plume (116) and impinges on the surface (104) of the substrate (102), wherein the at least one heating laser beam (162) simultaneously heats the surface (104) of the substrate (102) and the vapour plume (116).

8. A method (200) of coating, the method comprising:
providing an evaporant source (110) within an open environment (108) comprising air at atmospheric pressure, the evaporant source (110) comprising a coating material (112);
providing a substrate (102) within the open environment (108), the substrate (102) comprising a surface (104) disposed proximal to the evaporant source (110);
impinging, via an energy beam source (120), an emission region (114) of the evaporant source (110) with at least one energy beam (122) to generate a vapour plume (116) at the emission region (114), the vapour plume (116) comprising the coating material (112) of the evaporant source (110); and
positioning, via a fixture (130), the evaporant source (110) relative to the substrate (102) within the open environment (108), such that a maximum distance (124) between the emission region (114) of the evaporant source (110) and the surface (104) of the substrate (102) is less than or equal to 10 cm, wherein the maximum distance (124) enables the vapour plume (116) to travel directly from the evaporant source (110) to the surface (104) of the substrate (102) through the open environment (108) thereby coating the surface (104) of the substrate (102).

9. The method (200) of claim 8, wherein the maximum distance (124) is less than or equal to 2 mm and greater than zero.

10. The method (200) of claim 8 or claim 9, further comprising heating, via a heat source (134), the substrate (102) to a predetermined temperature (T).

11. The method (200) of any one of claims 8 to 10, further comprising:
generating, via a gas source (140), at least one jet of carrier gas (142);
at least partially entraining the vapour plume (116) in the at least one jet of carrier gas (142); and
transporting, via the at least one jet of carrier gas (142), the vapour plume (116) to the surface (104) of the substrate (102).

12. The method (200) of claim 11, further comprising heating, via the at least one jet of carrier gas (142), at least the surface (104) of the substrate (102).

13. The method (200) of any one of claims 8 to 12, further comprising forming, via a bond coater (126), a bond coat layer (128) of the substrate (102), such that the bond coat layer (128) defines the surface (104) of the substrate (102).

14. The method (200) of any one of claims 8 to 13, further comprising
emitting, via a laser source (150), at least one laser beam (152); and
transmitting, the at least one laser beam (152) through the vapour plume (116), such that the at least one laser beam (152) heats the vapour plume (116),
wherein the laser source (150) is a convergent laser source or a collimated laser source and the at least one laser beam (152) is at least one convergent or collimated laser beam.

15. The method (200) of any one of claims 8 to 14, further comprising:
emitting, via a heating laser source (160), at least one heating laser beam (162);
transmitting the at least one heating laser beam (162) through the vapour plume (116); and
simultaneously heating, via the at least one heating laser beam (162), the surface (104) of the substrate (102) and the vapour plume (116).
